# EUROPEAN PATENT APPLICATION

(11) **EP 1 564 816 A1**
(43) Date of publication of application: **17.08.2005**
(21) Application number: 05002227.6
(22) Date of filing: 03.02.2005
(51) Int. Cl.: H01L 31/048

(54) **Curved photovoltaic module and its production method**

(30) Priority: 16.02.2004 IT MI20040253
(71) Applicant: Curvet SPA, 61022 Bottega Di Colbordolo (Pesaro) (IT)
(72) Inventor: Bartolucci, Roberto, 61100 Pesaro (IT); Di Filippo, Andrea, 64015 Nereto (TE) (IT)
(74) Representative: Petruzziello, Aldo

(57) **Abstract**

The present invention refers to a photovoltaic module (100) or panel of curved glass and an industrial-technological method through which said module can be obtained. The stratification (lamination) of the components making up the final product takes place through sophisticated technological equipment such as: an autoclave, wherein the materials are processed in a high-temperature, high-pressure atmosphere; a medium-high vacuum pump, used to shape some components; a curving and tempering furnace, to shape and to temper the sheets of glass.

In the construction field, said photovoltaic module (100) is particularly suitable to be applied in thermally and acoustically insulated (soundproofing) curved glazing.

The unique feature of the photovoltaic module (100) is that the glass sheet 4 and the photovoltaic cells 1 are curved so as to give a curved shape thereto.

## Description

The present invention refers to a curved glass photovoltaic module or panel, to the production method for said photovoltaic module and to a thermally and acoustically insulated glazing obtained with the use of said photovoltaic soundproofing module. The shape of said module is able to satisfy any architectural design arrangement.

Building architecture is currently proposing structures with increasingly enveloping shapes. Furthermore, buildings are constructed which must be autonomous from the point of view of energy and climate, whilst respecting the environment. For this reason the market requires photovoltaic modules able to be used both in continuous facades and in roofs; at the same time said modules must be able to withstand the mechanical stresses to which they are subjected in said structures.

Object of the present invention is to provide a versatile, mechanically robust, curved photovoltaic module, suitable to be produced in diverse shapes in order to adapt to the structures on which it is destined to be mounted.

Another object of the present invention is to provide a photovoltaic module or panel that is able to ensure high efficiency and yield.

Another object of the present invention is to provide a photovoltaic module that is able to ensure a high resistance to severe weather conditions and is thus long lasting.

Another object of the present invention is to provide a thermally and acoustically insulating glazing with relative photovoltaic panel particularly suitable to be applied in the building field.

Another object of the present invention is also to succeed in mechanically curving and shaping the cells without causing any deformation, fracture or crystalline micro-fracture thereof (though the cells have a thickness of about 300 µm ÷ 500µm).

These objects are achieved according to the invention with the photovoltaic module and the relative production method whose characteristics are listed in appended independent claims 1 and 28.

Advantageous embodiments of the invention are apparent from the dependent claims.

The photovoltaic module according to the invention comprises a laminate consisting of a glass sheet destined to face towards a light source, of a supporting panel and of energy conversion means disposed between the glass sheet and the supporting panel. The peculiarity of the photovoltaic module according to the invention is that the glass sheet and the supporting panel are curved so as to give the module a curved shape.

In particular monocrystalline, polycrystalline or amorphous silica (Si) or gallium arsenide (GaAs) photovoltaic cells can be used as energy conversion means.

The module according to the invention has various advantages.

Said photovoltaic module has greater efficiency at sunrise and sunset because, due to the appropriate curvature of the glass sheet 4, the module offers a larger sun-trapping surface in these hours. Furthermore, the module according to the invention is particularly suitable to be applied to curved glazing (continuous facades) in the building field, since it is produced with different radii of curvature.

Said photovoltaic module is versatile and suited to different application fields, such as: building, urban and non-urban street furnishing (road signs, soundproofing road barriers, advertising boards and signs, lamp posts, shelters, garden lights), naval furnishing and automotive furnishing.

The invention also provides for the realization, through said panels, of double-glazing modules for the production of thermally and acoustically insulating glazing (continuous curved facades).

Further characteristics of the invention will be clearer from the detailed description that follows, referring to a purely exemplary and therefore non limiting embodiment thereof, illustrated in the appended drawings, in which:
Figure 1 is a perspective view illustrating the front surface of a curved photovoltaic module according to the invention, provided with a peripheral frame;
Figure 2 is a diagrammatic, partially broken off view of the module of Figure 1, without the peripheral frame, cross-sectioned along the section plane II-II of Figure 1;
Figure 3 is a perspective view illustrating the rear surface of the photovoltaic module of Figure 1;
Figure 4 is a diagrammatic plan view illustrating various types of energy conversion means of the photovoltaic type used in the photovoltaic module according to the invention;
Figures 5a - 5g illustrate various different shapes of curved photovoltaic modules according to the invention; and
Figure 6 illustrates an insulating glazing to which a curved photovoltaic module according to the invention is applied.

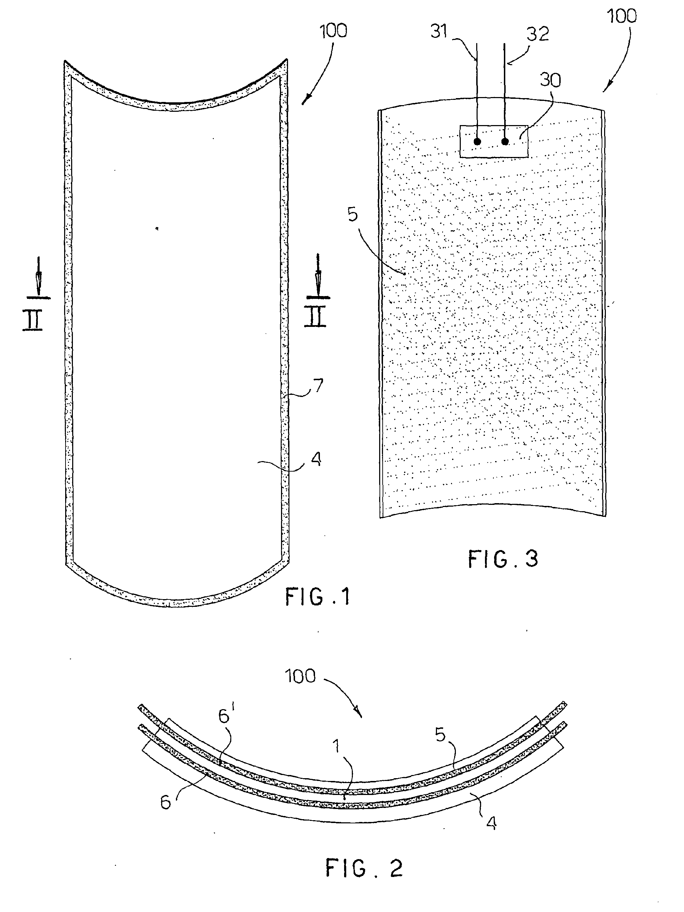

With reference to Figures 1 - 3, a photovoltaic module or panel, indicated as a whole with reference numeral 100, is shown. The photovoltaic module 100 comprises:
- a suitably curved glass sheet 4 (concave or convex), destined to face towards the light source,
- a supporting panel 5 suitably curved with the same centre of curvature as the glass sheet 4, and
- energy conversion means 1, interposed between the glass sheet 4 and the supporting panel 5 and able to convert the incident light radiation (photons) into a flow of electrons (e⁻) and lacunae (e⁺) (electrical current).

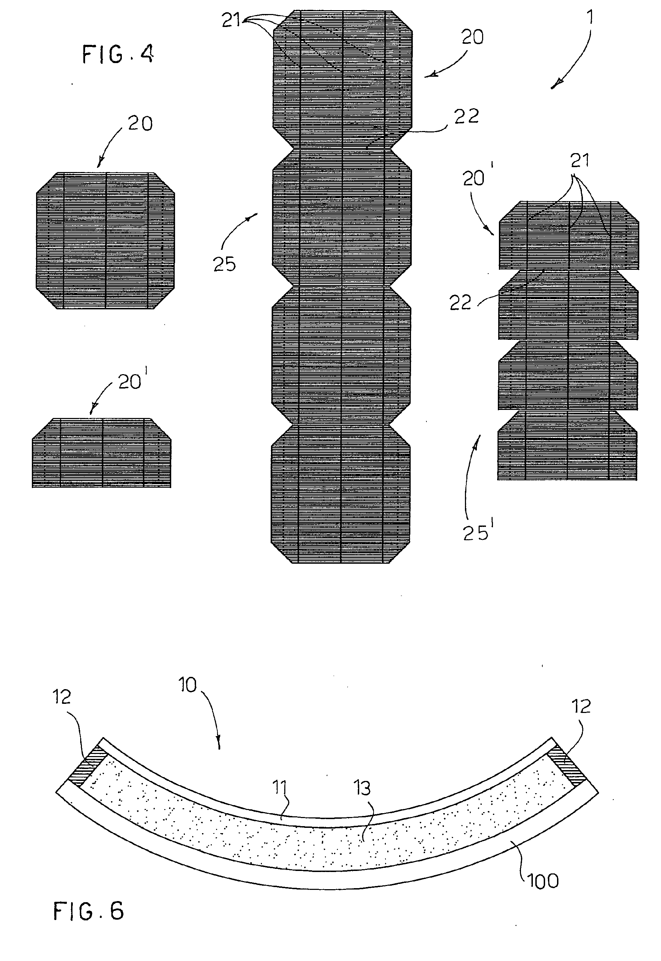

According to the amount of energy required (W_{P}) and to the development of the module 100, as shown in Figure 4, the energy conversion means 1 can comprise one or more photovoltaic cells 20, one or more photovoltaic half-cells 20', one or more strings 25 of photovoltaic cells 20 or one or more strings 25' of photovoltaic half-cells 20'. By way of example, the single photovoltaic cell 20 is substantially square-shaped with chamfered corners (pseudosquare), having a minimum surface of 2 cm² and a maximum surface of 1 m² and a thickness of about 300 - 500 µm. It is clear that cells with other geometrical shapes, such as rectangular, circular, etc. are also known to the art.

A single string (25, 25') consists of a single cell (20, 20') or more commonly of a plurality of photovoltaic cells 20 or of half-cells 20' electrically interconnected in series by means of bus-bars 21 of silver alloy (Ag) and soldered with tin (Sn) with a high silver content. A gap 22 of about 2 mm is left between one cell (20, 20') and the next. Even if four cells or half-cells (20, 20') interconnected in series are shown in Figure 4, a string (25, 25') comprises a number of cells, which can range from 1 to 16.

Again according to the amount of energy required (W_{P}) and to the development of the module 100, the cells 20 can be of monocrystalline, polycrystalline or amorphous silica (Si) or of gallium arsenide (GaAs). In fact, the choice of one type or of another type of material to form a photovoltaic cell depends upon the radius of curvature of the glass sheet and the energy yield required from said module, as well as from particular architectural requirements.

Cells of monocrystalline or polycrystalline silica are able to ensure high efficiency and high yield.

Cells in amorphous silica deposited on a flexible substrate are deformable and therefore allow photovoltaic modules to be produced with any curved shape, even with a strongly accentuated one.

Gallium arsenide cells are used where very high powers are required in small curved surfaces.

The photovoltaic module 100 can comprise only one string (25, 25') or a group of strings electrically connected to each other, in series or in parallel, by means of bus bars of conductive material, again of an Ag alloy. A single module 100 preferably contains no more than eight strings.

The connecting bus bars are soldered with tin (Sn) with a high content of silver (Ag). The bus-bars act as electrical connections and serve to convey the voltage and the electrical current generated by the cells or half-cells (20, 20') towards an electrical collection box 30 housed in the rear surface of the module 100, that is to say on the supporting panel 5. Electrical contacts 31 and 32, coming out of the electrical box 30, are the cathode (+) and the anode (-) of the module 100.

Inside the electrical box 30 there are diodes called "by-pass" diodes, to avoid the occurrence of so-called hotspots events caused by the complete shading of one or more cells of the module 100. The by-pass diodes are connected in antiparallel to each module 100, in order to provide an alternative pathway for the electrical current in the event of obscuring or of failure of the module 100.

The photovoltaic module 100 is assembled by means of a lamination (stratification) process, in which the energy conversion means 1 are placed between the curved glass sheet and the supporting panel 5.

From the aforementioned, it can be inferred that if the energy conversion means are amorphous silica photovoltaic cells, which are per se flexible, any curvature of the glass sheet 4 and of the supporting panel 5 can be done. If monocrystalline or polycrystalline silica or gallium arsenide (GaAs) photovoltaic cells are used, the radius of curvature of the glass sheet 4 and of the supporting panel 5 must be carefully designed to avoid damaging the photovoltaic cells.

In particular the applicant, after various experimental tests, has established a limit value for the radius of curvature, beyond which the crystalline structure of the silica or of the gallium arsenide undergoes deformations or micro-fractures which compromise the correct functioning of the cell.

Tempered glass about 3 mm thick is used to obtain the glass sheet 4. The glass sheet 4 is curved and tempered in technologically advanced furnaces. For the glass sheet 4 extra clear float glass is used. The supporting panel 5 is smaller in thickness than the glass sheet 4.

If plastic material is used for the supporting panel 5, this material is known by the name of Tedlar and consists of two layers of PVC (polyvinyl chloride) and of one layer of polyester (PET). Given the reduced thickness, we can talk of a "Tedlar sheet". The supporting panel 5 can be made of glass; in this case the thickness is variable.

In both cases the rear panel 5 (bottom layer) has the same centre of curvature as the outer glass sheet (concave or convex) 4 facing towards the light source. Both materials (Tedlar or glass) ensure an excellent resistance to abrasion and to corrosion by atmospheric agents. Tedlar is also an excellent electrical and thermal insulator besides being waterproof.

Furthermore, the glass placed in the bottom part of the module (which therefore acts as a supporting panel 5) can be transparent, extra-clear, frosted, coloured, reflective, low-emission, etc.

The thickness of said supporting panel 5 is less than the thickness of the glass sheet 4, in the case of a Tedlar sheet being used; otherwise, if a second glass sheet is used as a support, this can have a thickness ranging from 3 to 12 mm. Furthermore, more than one glass can be stratified to act as a supporting panel 5; each of these can be of a thickness ranging from 3 to 12 mm.

The lamination (stratification) process of the module 100 takes place by means of the use of a first layer 6 of plastic material [positioned] between the glass sheet 4 and the energy conversion means 1 and a second layer 6' of plastic material [positioned] between the energy conversion means 1 and the supporting panel 5.

The plastic material used can consist of polymers, such as PVC, PVB, PET, PU, EVA. EVA (Ethyl Vinyl Acetate), it ensures a high transparency and gives the product the typical characteristics of a soundproofing panel. In fact the layers of plastic material (6, 6') contribute to attenuate the intensity of incident sound waves and to modify the direction of propagation of said waves when they pass through materials of different density (sound refraction). The module 100 can be used as a soundproofing panel and/or in an acoustically insulating glazing.

The layers 6, 6' of plastic material are treated with special glues (Betaprime™ by DOW) and catalysed bi-component epoxy resins, which are compatible with the material of the plastic layers (6, 6'), with the glass sheet 4, with the energy conversion means 1 and with the supporting panel 5.

To be precise, the first layer 6 of plastic material is disposed between the concave or convex face of the curved glass sheet 4 and the sensitive surface (silica or gallium arsenide layer) of the energy conversion means 1, whilst the second layer 6' of plastic material is applied between the substrate of the energy conversion means 1 and the supporting panel 5.

The inner surface of the glass sheet 4 is treated with solvents (Betaclean™ by DOW) and serigraphy varnishes are deposited thereon. The outer surface of the glass sheet 4, on the other hand, is treated with a water-repellent product (Doctor Brill™ produced and marketed by the applicant), which promotes running off of rainwater, preventing the formation of lime-scale marks, and removal of dirt and dust. In this manner the transparency of the glass remains unchanged, consequently maintaining the excellent operation of the photovoltaic panel unchanged.

The lamination (stratification) process is a very delicate operation, in that it is necessary to take the utmost care during layering of the materials. In fact errors in the layering operation lead to poor functioning of the module 100, which can even result in discarding of the final product.

Preparation and storage of the materials takes place in a chamber with controlled temperature and humidity.

Besides having a climatization system the chamber is provided with a filtering system (a hood) for the chemical fumes deriving from the glues, from the resins and from the varnishes used and is provided with a dust filtering system (the dust, if present, may compromise perfect adhesion of the different materials).

After the assembly of all the components, the module is placed in a vacuum to expel any air bubble between the various layers of the module (4, 6, 1, 6', 5) represented by the different materials placed on the "different levels" (layers).

In order to obtain the end product, it has been necessary to research and to study the thermal characteristics of each component on the basis of the apparatus available, since the assembled product must be subjected to a complete cycle in an autoclave. In fact the temperature is monitored at each step of the cycle through sensitive thermocouples.

After the process of lamination of the module 100, a layer of silicone compatible with the other materials used and a plastic gasket, covered by an aluminium frame 7 (Figure 1) is deposited on the edge of the panel 100 in order to seal the edge of the module perfectly and thus even further avoid the possibility of delamination due to moisture infiltrations.

The electrical box 30 is also hermetically sealed with silicone glues compatible with the rest of the materials, in the rear part of the module 5 (as already mentioned above). Electrical cables 31 and 32 come out of the electrical box 30 for connection of the module 100 in series or in parallel with other modules.

The frame 7, usually of aluminium, is applied to the module to facilitate the joining of a plurality of modules and to give each panel a greater mechanical strength (already ensured by the fact the module is made with stratified tempered glass). The lamination and tempering process of the glass also makes the module withstand the mechanical structural stresses to which it may be subjected when it is applied, usually in the building sector.

It should be noted that the graphic representation provided in Figure 1 represents the module 100 with an convex surface facing outward, that is to say towards the light source and a concave surface facing inward, that is to say in the opposite direction to the light source. Thus the layer of silica or gallium arsenide, which is the most sensitive part of the energy conversion means 1, will be curved with a convex surface facing towards the light source.

However, in exactly the same manner, the module 100 can have a concave surface facing towards the light source.

Figure 6 shows a curved insulating glazing 10, which uses the photovoltaic module 100. The curved insulating glazing 10 is formed by coupling to the rear of the curved glass sheet 4 another glass sheet 11 (having the same centre of curvature as the sheet 4), by means of a peripheral seal 12, so as to create a space 13 (between the convex surface of the glass sheet 11 and the concave surface of the Tedlar 5 of the air-containing panel 100), the thickness of which can vary from 6 mm to 24 mm. The glass sheet 11 can be of variable thickness.

The peripheral seal 12 ensures impermeability to the water and to any vapour. It is made by means of silicone glues (DOW Coming 3540™) with a high mechanical grip and compatible with all the other materials used and by means of a Swiggle Strip™. The latter is a completely ecological product with no toxicological risk.

The glass sheet 11 intended to face towards the inside of the building can be transparent, stained, frosted, sand-blasted, stratified, tempered, low emission, reflective, etc.

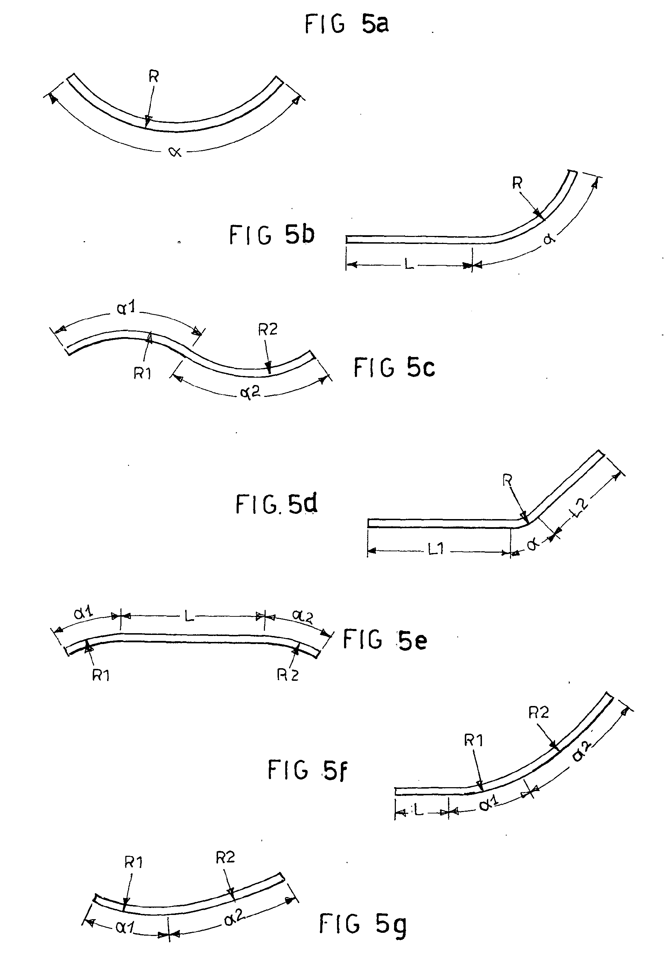

With reference to Figures 5a - 5g seven possible configurations of a curved module 100 according to the invention are illustrated by way of example.

In Fig. 5a a module having a constant radius of curvature indicated by R and an angular development indicated by α are illustrated.

In Fig. 5b a module having a portion with a radius of curvature R and a flat portion with a length L is illustrated.

In Fig. 5c a module having a convex portion with a radius of curvature R1 and a concave portion with a radius of curvature R2 is illustrated.

In Fig. 5d a module having two flat portions, one with a length L1 and the other with a length L2, connected to each other by a curved portion with a radius of curvature R, is illustrated.

In Fig. 5e a module having a flat portion with a length L, at the extremities of which two curved portions with radii of curvature R1 and R2, respectively, are provided, is illustrated.

In Fig. 5f a module having a first flat portion with a length L, a second curved portion with a radius of curvature R1 and a third curved potion with a radius of curvature R2 is illustrated.

In Fig. 5g a module having a first portion with a radius of curvature R1 and a second portion with a radius of curvature R2 is illustrated.

In Fig. 6 a photovoltaic panel 100 applied to an insulating glazing 10, particularly suitable to be used in building, is illustrated.

Numerous variations and modifications of detail deriving from technical-scientific knowledge of the processes and the product can be made to the present embodiment of the invention, without thereby departing from the scope of the invention, as set forth in the appended claims.

## Claims

1. A photovoltaic module (100) comprising:
- a glass sheet (4) destined to face towards a light source;
- a supporting panel (5); and
- energy conversion means (1) disposed between said glass sheet (4) and said supporting panel (5),
**characterised in that**
at least one portion of said glass sheet (4) and least one corresponding portion of said supporting panel (5) are concave or convex curved, essentially with the same centre of curvature.

2. A photovoltaic module (100) according to claim 1, **characterised in that** said glass sheet (4) has a convex part facing outwards and a concave part facing inwards and towards the sensitive part of said energy conversion means (1).

3. A photovoltaic module (100) according to claim 1 o 2, **characterised in that** the thickness of said glass sheet (4) is about 3 mm.

4. A photovoltaic module (100) according to any one of the preceding claims, **characterised in that** said energy conversion means (1) comprise at least one photovoltaic cell (20) or at least one photovoltaic half-cell (20').

5. A photovoltaic module (100) according to claim 4, **characterised in that** said energy conversion means (1) comprise at least one string (25, 25') of cells (20) or of photovoltaic half-cells (20') electrically interconnected in series with each other, by means of bus-bars (21) of a conductive material.

6. A photovoltaic module (100) according to claim 5, **characterised in that** said strings (25, 25') are electrically connected to each other in series or in parallel.

7. A photovoltaic module (100) according to any one of claims 4 to 6, **characterised in that** said photovoltaic cell (20, 20') consists of monocrystalline or polycrystalline silica or of gallium arsenide (GaAs).

8. A photovoltaic module (100) according to claim 7, **characterised in that** the radius of curvature of the curved portions of the glass sheet (4) and of the supporting panel (5) does not exceed a limit value beyond which deformations or micro fractures of the crystalline structure of the photovoltaic cell (20, 20') occur.

9. A photovoltaic module (100) according to claim 5 or 6, **characterised in that** said photovoltaic cell (20, 20') consists of amorphous silica deposited on a flexible substrate and able to be curved and adapted to any radius of curvature of said glass sheet (4) and of said supporting panel (5).

10. A photovoltaic module (100) according to claim 9, **characterised in that** said flexible substrate of the amorphous silica photovoltaic cell is a sheet of flexible material.

11. A photovoltaic module (100) according to any one of claims 4 to 10, **characterised in that** said photovoltaic cell (20, 20') is of any geometric shape: rectangular, square, circular, with a minimum size of 2 cm², a maximum size of 1 m² and a thickness between 300 µm and 500 µm.

12. A photovoltaic module (100) according to any one of the preceding claims, **characterised in that** said supporting panel (5) is made of plastic material or of glass.

13. A photovoltaic module (100) according to claim 12, **characterised in that** said supporting panel (5) of plastic material comprises a Tedlar sheet consisting of two layers of PVC (polyvinyl chloride) and of a layer of PET polyester.

14. A photovoltaic module (100) according to claim 13, **characterised in that** the thickness of said supporting panel (5) is less than the thickness of said glass sheet (4).

15. A photovoltaic module (100) according to any one of the preceding claims, **characterised in that** a first layer (6) of plastic material is disposed between said curved glass sheet (4) and said energy conversion means (1) and a second layer (6') of plastic materials is disposed between said energy conversion means (1) and said supporting panel (5).

16. A photovoltaic module (100) according to claim 15, **characterised in that** said layers of plastic material (6, 6') consist of EVA (Ethyl Vinyl Acetate), PVC, PVB, PET or PU.

17. A photovoltaic module (100) according to claim 15 o 16, **characterised in that** said layers of plastic material (6, 6') are treated with glues or with bi-component catalysed adhesive resins to promote their adhesion to the glass sheet (4) and to the supporting panel (5).

18. A photovoltaic module (100) according to any one of the preceding claims, **characterised in that** it comprises an electrical box (30), disposed behind the supporting panel (5), from which the cathode (31) and the anode (32), that is the electrical contacts of the module, are extracted and within which by-pass diodes are housed to avoid the occurrence of "hot-spots" phenomena caused by the total shading of one or more cells of the module (100).

19. A photovoltaic module (100) according to claim 17, **characterised in that** said electrical box (30) is sealed on the rear face of the supporting panel (5) of the module.

20. A photovoltaic module (100) according to any one of the preceding claims, **characterised in that** said curved glass sheet (4) is made of extra-clear tempered float glass.

21. A photovoltaic module (100) according to any one of the preceding claims, **characterised in that** it includes a peripheral seal and a peripheral frame (7).

22. A photovoltaic module (100) according to any one of the preceding claims, **characterised in that** it is used as an anti-vandalism and soundproofing glass.

23. Glazing (10) for building applications, **characterised in that** it comprises at least one photovoltaic module (100) according to any one of the preceding claims.

24. Glazing (10) according to claim 23, **characterised in that** it comprises a glass sheet (11) applied to said photovoltaic module 100, so as to give rise to a space (13) between said glass sheet (11) and said photovoltaic module (100).

25. Glazing (10) according to claim 24, **characterised in that** said space (13) contains air and has a thickness of about 6 - 24 mm.

26. Glazing (10) according to claim 24 or 25, **characterised in that** said glass sheet (11) is coupled to said module (100) by means of a peripheral seal (12) made with silicone glues with a high mechanical grip compatible with all the other materials used and by means of Swiggle Strips™.

27. Glazing according to any one of claims 23 to 26, **characterised in that** said glass sheet (11) is curved with the same centre of curvature as that of the module (100) and faces towards the supporting panel (5) of the module (100).

28. A method for the production of a photovoltaic module (100) according to any one of claims 1 to 22, comprising the following steps:
- curving of a glass sheet (4),
- curving of a supporting panel (5) with the same centre of curvature as the glass sheet (4),
- interposing, between the glass sheet (4) and said supporting panel (5), of energy conversion means (1) able to convert solar radiation (light/photons) into a flow of electrons and lacunes (electrical current), and
- lamination (stratification) of said glass sheet (4), of said supporting panel (5) and of said energy conversion means (1).

29. A method according to claim 28, **characterised in that** it further comprises the application of a first layer (6) of plastic material between said curved glass sheet (4) and said energy conversion means (1) and of a second layer of plastic material (6') between said energy conversion means (1) and said supporting panel (5).

30. A method according to claim 29, **characterised in that** it further comprises the application of glues or of adhesive resins on said two layers of plastic material (6, 6').

31. A method according to claim 29 or 30, **characterised in that** said module (100) is placed in a vacuum during an autoclave cycle to eliminate the presence of possible air bubbles between the various layers of which it is composed.
